## Europäisches Patentamt
## European Patent Office
## Office européen des brevets

(19)

(11) Numéro de publication : **0 162 743**
**B1**

(12)

# FASCICULE DE BREVET EUROPÉEN

(45) Date de publication du fascicule du brevet :
09.08.89

(51) Int. Cl.⁴ : **H 02 M   1/08**, H 03 K 17/13

(21) Numéro de dépôt : 85400761.4

(22) Date de dépôt : 17.04.85

(54) **Ensemble de commutation à semi-conducteur mono-directionnel en courant et bi-directionnel en tension à blocage commandé et à amorcage spontané.**

(30) Priorité : 20.04.84 FR 8406286

(43) Date de publication de la demande :
27.11.85 Bulletin 85/48

(45) Mention de la délivrance du brevet :
09.08.89 Bulletin 89/32

(84) Etats contractants désignés :
AT BE CH DE FR GB IT LI NL SE

(56) Documents cités :
EP—A— 0 035 379
DE—A— 2 325 881
FR—A— 2 499 789

(73) Titulaire : JEUMONT-SCHNEIDER Société anonyme
dite:
31-32, Quai de Dion Bouton
F-92811 Puteaux Cedex (FR)

(72) Inventeur : Foch, Henri
33, rue Jean Tallien
F-31200 Toulouse (FR)
Inventeur : Duparc, Jacques
39, Chemin de la Ségognole Noisy-sur-Ecole
F-77123 Le Vaudoue (FR)

(74) Mandataire : Phélip, Bruno et al
c/o Cabinet Harlé & Phélip 21, rue de La Rochefoucauld
F-75009 Paris (FR)

## Description

La présente invention concerne l'électronique notamment dite de puissance et, plus particulièrement un ensemble de commutation à semiconducteur mono-directionnel en courant et bi-directionnel en tension à blocage commandé et à amorçage spontané mettant en oeuvre un semiconducteur à commutations commandées.

Ainsi le brevet EP 00 35 379 est relatif à un circuit de commutation pour un thyristor, comprenant un comparateur dont une entrée est connectée à l'anode du thyristor et dont l'autre entrée est connectée à une source de tension de valeur déterminée, la sortie du comparateur étant connectée à une porte logique ET dont l'autre entrée est connectée à un circuit générateur de signal de commande d'amorçage, et dont la sortie est connectée à la borne de commande du thyristor par l'intermédiaire d'un circuit amplificateur.

Ce circuit fournit un courant d'amorçage sur la borne de commande du thyristor quand la tension anode-cathode du thyristor est supérieure à un seuil déterminé et une commande d'amorçage donnée. Ce circuit coupe le courant d'amorçage quand la tension anode-cathode devient inférieure au seuil. Ainsi, le temps de conduction du courant d'amorçage est rendu aussi petit que possible.

Ce circuit de commutation est conçu pour un thyristor à amorçage commandé et à blocage spontané, qui permet de limiter automatiquement la durée de l'impulsion d'amorçage du thyristor afin de réduire la consommation d'énergie.

Dans certains cas, il est intéressant d'utiliser des semi-conducteurs dont le blocage peut être commandé.

On connait par exemple les thyristors à commutations commandées dits thyristors GTO. Ces thyristors sont tels qu'ils deviennent passants (s'amorcent) si la tension entre l'anode et la cathode et le courant sont positifs et si une impulsion positive est appliquée à la gachette et qu'ils se bloquent soit lorsque le courant circulant de l'anode vers la cathode devient négatif ou nul, soit, quand ce courant est positif, lorsqu'une impulsion négative est appliquée à la gachette.

Ces thyristors présentent de nombreux avantages. Toutefois, pour certaines applications, il est souhaitable de rendre automatique l'amorçage d'un tel thyristor tout en conservant la propriété caractéristique constituée par la possibilité de commander le blocage du thyristor. En effet, il est avantageux de supprimer tout circuit d'aide à la commutation d'amorçage.

Le but de la présente invention est de réaliser un ensemble à semi-conducteur présentant cette double caractéristique.

L'invention est relative à un ensemble de commutation à semi-conducteur mono-directionnel en courant et bidirectionnel en tension comprenant une porte logique à l'une des entrées de laquelle est appliqué le signal logique délivré par un premier circuit d'adaptation relié à l'anode du semiconducteur, lorsque la tension entre l'anode et la cathode de ce dernier est inférieure à une tension positive déterminée, à l'autre entrée de laquelle est appliqué un signal logique de commande et à la sortie de laquelle est relié un second circuit d'adaptation transformant le signal logique délivré par cette porte logique en un signal de commande approprié appliqué à la borne de commande du semi-conducteur.

Selon l'invention le semi-conducteur est un semiconducteur à commutations commandées, la porte logique envoyant un signal de blocage au second circuit d'adaptation quand elle reçoit le signal logique et un signal logique de commande de blocage, le second circuit d'adaptation envoyant un signal de commande à la borne de commande du semiconducteur pour amorcer le semi-conducteur en l'absence de signal de blocage délivré par la porte logique, et envoyant un signal de commande à la borne de commande du semi-conducteur pour bloquer celui-ci en réponse à un signal de blocage délivré par la porte logique.

Cette porte logique peut être constituée par une porte OU, ou de préférence, par une porte NI (NOR).

Le semi-conducteur mis en oeuvre peut aussi bien être un thyristor du type à commutations commandées appelé GTO, dont la gachette constitue la borne de commande, que constitué par un transistor dont la base est la borne de commande et dont le collecteur est l'anode à laquelle est reliée la cathode d'une première diode dont l'anode est reliée d'une part à l'émetteur du transistor et d'autre part à l'anode d'une seconde diode dont la cathode constitue la cathode du semi-conducteur.

Un tel ensemble de commutation trouve son application par exemple dans les convertisseurs continu-continu directs ou indirects, continu-alternatif, (notamment les ponts de GRAETZ) ou alternatif-continu. Il trouve également son application dans la réalisation d'un gradateur capacitif destiné à fournir une puissance réactive variable.

La présente invention sera mieux comprise et d'autres buts, avantages et caractéristiques de celle-ci apparaîtront plus clairement à la lecture de la description qui suit, donnée à titre non limitatif, et à laquelle une planche de dessins est annexée.

Les figures 1 et 2 représentent schématiquement un premier et un second modes de réalisation de l'ensemble de commutation conformément à l'invention dans lequel le semiconducteur est un thyristor.

La figure 3 représente partiellement un ensemble identique dans lequel le semi-conducteur est constitué par un transistor et deux diodes conformément à un aspect de l'invention.

La figure 4 illustre schématiquement la réalisation d'un gradateur capacitif mettant en œuvre

des ensembles conformes à l'invention.

La figure 5 représente schématiquement un convertisseur du type pont de Graetz commandant un moteur asynchrone mettant en œuvre des ensembles conformes à l'invention.

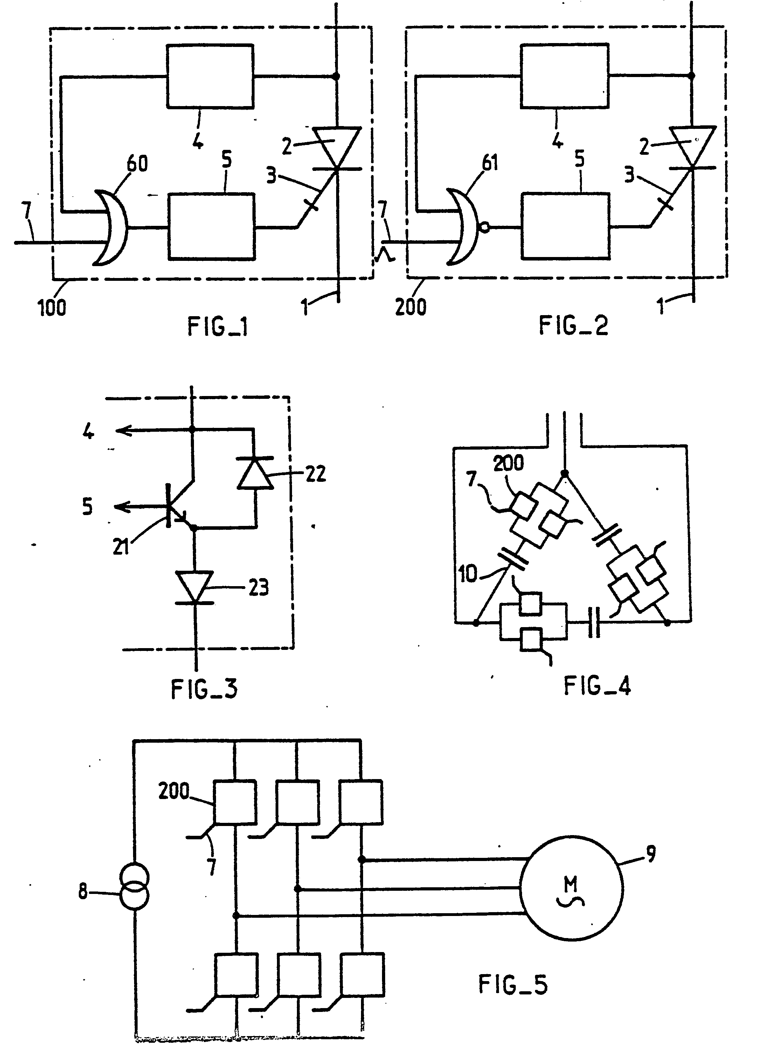

En référence aux figures 1 et 2 représentant deux modes de réalisation de l'invention, le semi-conducteur est un thyristor à commutations commandées 2 qui a ses anode et cathode reliées à un circuit de puissance 1 dont la charge et la source n'ont pas été représentées.

Un premier circuit d'adaptation 4 détecte la tension anode cathode du thyristor 2 et délivre le niveau logique zéro lorsque cette tension est inférieure à une valeur positive déterminée voisine de zéro. Ce signal logique est appliqué a la première entrée d'une porte logique 60, 61 dont la seconde entrée 7 est reliée au circuit de commande de blocage.

Un second circuit d'adaptation 5 transforme le signal logique issu de la porte logique 60, 61 en un signal approprié de commande appliqué à la gachette 3 du thyristor 2.

Sur la figure 1, la porte logique est une porte OU tandis que sur la figure 2, cette porte logique est une porte NI.

Ces éléments constituent l'ensemble de commutation représenté schématiquement en traits mixtes 100 sur la figure 1 et 200 sur la figure 2.

Le fonctionnement d'un tel ensemble de commutation est le suivant, en se référant par exemple à la figure 2, puisque l'on préfère utiliser une porte logique NI comme représenté figure 2.

Lorsque la tension entre l'anode et la cathode du thyristor 2 passe par une valeur inférieure à une valeur positive déterminée voisine de zéro, le premier circuit d'adaptation 4 délivre un signal logique constant de valeur symbolique 0, signal qui est appliqué à une entrée de la porte NI 61. Il en résulte, si aucun ordre de blocage n'est donné, c'est-à-dire si le signal logique appliqué à l'autre entrée de la porte NI 61 a une valeur symbolique 0, qu'un signal de valeur symbolique 1 à la sortie de cette porte NI 61 est appliqué au second circuit d'adaptation 5, lequel délivre sur la gachette le signal approprié pour commander l'amorçage du thyristor 2. Cette tension entre anode et cathode restant faible, puisque le thyristor 2 est alors passant, et inférieure à la valeur déterminée, le signal logique issu du premier circuit d'adaptation 5 reste égal à la valeur symbolique 0 et tout ordre de blocage appliqué sur l'entrée 7 de la porte NI 61 sous forme d'un signal logique (par exemple une impulsion) de valeur symbolique 1, entraîne le changement d'état de la sortie de la porte NI. Il en résulte alors que le second circuit d'adaptation délivre sur la gachette du thyristor 2 le signal approprié de blocage, par exemple une impulsion de 100 Ampères si le courant à commuter a une valeur de 600 Ampères. .

Lors du blocage, la tension entre anode et cathode augmente et le premier circuit d'adaptation 4 délivre un signal logique de valeur symbolique 1 dont résulte le maintien de l'ordre de blocage, jusqu'à ce que la tension repasse par une valeur inférieure à la valeur positive déterminée où l'ordre d'amorçage sera donné par le changement d'état de ce dernier signal logique.

De préférence le premier circuit d'adaptation 4 est réalisé au moyen d'un comparateur présentant une certaine hystérésis de manière à éviter toute oscillation inopportune dans le changement d'état du signal logique de sortie de ce circuit d'adaptation tandis que le second circuit d'adaptation 5 peut être réalisé par une simple bascule astable en série avec un amplificateur approprié.

Sur la figure 3 on a représenté la partie modifiée de l'un ou l'autre ensemble de commutation permettant de mettre en œuvre un transistor et deux diodes. Le fonctionnement de l'ensemble est identique sauf en ce qui concerne le signal de commande à appliquer à la base du transistor. En effet, avec un thyristor, ce signal peut affecter la forme d'une impulsion positive ou négative selon la commande à exécuter tandis qu'avec un transistor, ce signal doit être constitué par une tension constante ou une absence de tension.

En quelques mots, le semi-conducteur 2 est constitué par un transistor 21 dont la base est la borne de commande et le collecteur l'anode à laquelle est reliée la cathode d'une première diode 22 dont l'anode est reliée d'une part à l'émetteur du transistor 21 et d'autre part à l'anode d'une seconde diode 23 dont la cathode constitue la cathode du semi-conducteur 2 proprement dit.

Les autres figures représentent deux types d'application d'un tel ensemble de commutation conformément à l'invention.

On a représenté par exemple figure 4 l'application de l'ensemble de commutation conforme à l'invention à la réalisation d'un gradateur capacitif permettant de fournir une puissance réactive, dans une ligne d'alimentation.

On peut par exemple utiliser une branche comportant deux éléments à thyristor 200 tête-bêche en parallèle, montés en série avec un condensateur 10. Chaque branche pourra être disposée entre une phase de la ligne d'alimentation en puissance et un neutre artificiel flottant pour un montage en étoile (non représenté ici) ou dans le montage triphasé en triangle tel que représenté Figure 4, ce dernier présentant l'avantage complémentaire de supprimer les harmoniques multiples de trois.

Ce gradateur capacitif permet de fournir de la puissance réactive alors que, dans les compensateurs statiques connus qui mettent en œuvre des gradateurs selfiques, on fait au contraire circuler une puissance réactive entre une batterie de condensateurs fixes et le gradateur selfique.

L'Homme de l'Art reconnaîtra enfin figure 5 un convertisseur du type pont de GRAETZ dont les éléments sont constitués par des ensembles de commutation 200 dont l'entrée de la commande de blocage est représentée en 7. Un tel convertisseur permet par exemple de commander une charge selfique tel qu'un moteur asynchrone 9 présentant un cos arrière à partir de la source de courant continu 8 de façon connue en soi.

## Revendications

1. Ensemble de commutation à semi-conducteur mono-directionnel en courant et bi-directionnel en tension comprenant une porte logique (60, 61) à l'une des entrées de laquelle est appliqué un signal logique délivré par un premier circuit d'adaptation (4) relié à l'anode du semi-conducteur, lorsque la tension entre l'anode et la cathode de ce dernier est inférieure à une tension positive déterminée, à l'autre entrée de laquelle est appliqué un signal logique de commande, et à la sortie de laquelle est relié un second circuit d'adaptation (5) transformant le signal logique délivré par la dite porte logique en un signal de commande approprié appliqué à la borne de commande du dit semi-conducteur caractérisé en ce que le dit semiconducteur (2) est un semi-conducteur à commutations commandées, la dite porte logique (60, 61) envoyant un signal de blocage au second circuit d'adaptation (5) quand elle reçoit le dit signal logique et un signal logique de commande de blocage, le dit second circuit d'adaptation (5) envoyant un signal de commande à la borne de commande (3) du dit semiconducteur (2) pour amorcer le dit semi-conducteur en l'absence de signal de blocage délivré par la dite porte logique (60, 61) et envoyant un signal de commande à la borne de commande (3) du dit semi-conducteur (2) pour bloquer le dit semi-conducteur (2) en réponse à un signal de blocage délivré par la dite porte logique (60, 61).

2. Ensemble de commutation selon la revendication 1 caractérisé en ce que la dite porte logique (60) est une porte OU.

3. Ensemble de commutation selon la revendication 1 caractérisé en ce que la dite porte logique (61) est une porte NI.

4. Ensemble de commutation selon l'une quelconque des revendications 1 à 3 caractérisé en ce que le dit semiconducteur (2) est un thyristor du type à commutations commandées appelé GTO, dont la gachette (3) constitue la borne de commande.

5. Ensemble de commutation selon l'une quelconque des revendications 1 à 3 caractérisé en ce que le dit semiconducteur (2) est constitué par un transistor (21) dont la base est la borne de commande et dont le collecteur est l'anode à laquelle est reliée la cathode d'une première diode (22) dont l'anode est reliée d'une part à l'émetteur du dit transistor (21) et d'autre part à l'anode d'une seconde diode (23) dont la cathode constitue la cathode du dit semiconducteur (2).

6. Gradateur capacitif caractérisé en ce qu'il comprend au moins une branche constituée par deux ensembles de commutation selon l'une quelconque des revendications 1 à 5, disposé tête-bêche en parallèle et montés en série avec un condensateur (10).

7. Gradateur capacitif selon la revendication 6 caractérisé en ce que chaque branche est disposée entre une phase de la ligne d'alimentation en puissance et un neutre artificiel flottant dans un montage en étoile.

8. Gradateur capacitif selon la revendication 6 caractérisé en ce que, pour une ligne d'alimentation en puissance triphasée, les branches sont montées en triangle.

## Claims

1. A commutator containing a semi-conductor device of the unidirectional current and bidirectional voltage type comprising a logic gate (60, 61) having a first input which receives a logic signal transmitted by a first adaptor circuit means (4) connected to the anode of said semi-conductor device when the anode-to-cathode voltage of said semi-conductor device is less then a predetermined positive value, a second input which receives a control signal, and an output connected to a second adaptor circuit means (5) permitting conversion of the logic signal transmitted by said logic gate into an appropriate control signal transmitted to the control terminal of said semi-conductor device, characterized in that the said semi-conductor device (2) is of the controlled commutation type, the said logic gate (60, 61) outputting an interruption signal to said second adaptor circuit means (5) when it receives said logic signal and an interruption instruction signal, said second adaptor circuit means (5) providing a control signal to the said control terminal (3) of said semi-conductor device (2) to trigger said semi-conductor device absent an interruption signal output from said logic gate (60, 61) and providing a control signal to said control terminal (3) of said semiconductor device (2) to interrupt said semi-conductor device (2) in response to an interruption signal output from said logic gate (60, 61).

2. A commutator in accordance with claim 1, characterized by the fact that said logic gate (60) is an « OR » gate.

3. A commutator in accordance with claim 1, characterized by the fact that said logic gate (61) is a « NOR » gate.

4. A commutator in accordance with one of claims 1 to 3, characterized by the fact that said semi-conductor device (2) is a thyristor of the controlled commutation or G. T.0. type and wherein the trigger (3) of said thyristor constitutes said control terminal.

5. A commutator in accordance with one of claims 1 to 3, characterized by the fact that said semi-conductor device (2) is a transistor (21) whose base terminal constitutes said control terminal and whose collector terminal constitutes said anode terminal, said collector terminal being connected to the cathode of a first diode (22) whose anode is connected to the emitter of said transistor (21) and to the anode of second diode (23) whose cathode constitutes said cathode terminal of said semi-conductor device (2).

6. A capacitive regulator, characterized by the fact that it comprises at least one branch circuit including a pair of commutators designed in accordance with one of claims 1 to 5, connected in parallel, topto-bottom fashion and in series with a condenser (10).

7. A capacitive regulator in accordance with claim 6, characterized by the fact that each of the branches are placed between a phase of a power supply line and a floating artifical neutral within a Y-connection.

8. A capacitive regulator in accordance with claim 6, characterized by the fact that said branches are delta-connected for a three-phase power supply line.

**Patentansprüche**

1. Halbleiter-Schalteinheit, die für Ströme monodirektional und Spannung bidirektional schaltet, mit einer logischen Torschaltung (60, 61), an deren einen Eingang ein Logiksignal angelegt wird, das von einer ersten Anpaßschaltung (4) abgegeben wird, die mit der Anode des Halbleiters verbunden ist, wenn die Spannung zwischen der Anode und der Katode des Halbleiters kleiner als eine bestimmte positive Spannung ist, und an deren anderen Eingang ein Steuer-Logiksignal angelegt wird, während ihr Ausgang mit einer zweiten Anpaßschaltung (5) verbunden ist, welche das von der logischen Torschaltung abgegebene Logiksignal in ein geeignetes Steuersignal umsetzt, das an den Steueranschluß des Halbleiters angelegt wird, dadurch gekennzeichnet, daß dieser Halbleiter (2) ein Halbleiter mit gesteuerten Schaltzuständen ist, wobei die logische Torschaltung (60, 61) ein Sperrsignal an die zweite Anpaßschaltung (5) abgibt, wenn sie das Logiksignal und ein logisches Sperr-Steuersignal empfängt, wobei ferner die zweite Anpaßschaltung (5) ein Steuersignal an den Steueranschluß (3) des Halbleiters (2) abgibt, um diesen Halbleiter bei Fehlen des durch die logische Torschaltung (60, 61) abgegebenen Sperrsignals anzusteuern, und ein Steuersignal an den Steueranschluß (3) des Halbleiters (2) abgibt, um diesen Halbleiter (2) ansprechend auf ein Sperrsignal zu sperren, welches durch die logische Torschaltung (60, 61) abgegeben wird.

2. Schalteinheit nach Anspruch 1, dadurch gekennzeichnet, daß die logische Torschaltung (60) eine OR-Torschaltung ist.

3. Schalteinheit nach Anspruch 1, dadurch gekennzeichnet, daß die logische Torschaltung (61) eine NOR-Torschaltung ist.

4. Schalteinheit nach einem der Ansprüche 1 bis 3, dadurch gekennzeichnet, daß der Halbleiter (2) ein Thyristor vom Typ mit gesteuerten Schaltzuständen ist, der auch als GTO bezeichnet wird und dessen Steuerelektrode (3) den Steueranschluß bildet.

5. Schalteinheit nach einem der Ansprüche 1 bis 3, dadurch gekennzeichnet, daß der Halbleiter (2) durch einen Transistor (21) gebildet ist, dessen Basis den Steueranschluß bildet und dessen Kollektor die Anode ist, an welche die Katode einer ersten Diode (22) angeschlossen ist, deren Anode einerseits mit dem Emitter des Transistors (21) und andererseits mit der Anode einer zweiten Diode (23) verbunden ist, deren Katode die Katode des Halbleiters (2) bildet.

6. Kapazitiver Teiler, dadurch gekennzeichnet, daß er wenigstens einen Zweig aufweist, der aus zwei Schalteinheiten nach einem der Ansprüche 1 bis 5 gebildet ist, die in entgegengesetzter Polung parallelgeschaltet sind und in Reihe mit einem Kondensator (10) liegen.

7. Kapazitiver Teiler nach Anspruch 6, dadurch gekennzeichnet, daß jeder Zweig zwischen einer Phase der Stromversorgungsleitung und einem künstlichen Nullpunkt angeordnet ist, der in einer Sternschaltung frei schwimmt.

8. Kapazitiver Teiler nach Anspruch 6, dadurch gekennzeichnet, daß für eine Dreiphasen-Stromversorgungsleitung die Zweige dreieckförmig angeordnet sind.

FIG_1

FIG_2

FIG_3

FIG_4

FIG_5